# EUROPÄISCHE PATENTSCHRIFT

(11) **EP 3 417 683 B1**
(45) Veröffentlichungstag und Bekanntmachung des Hinweises auf die Patenterteilung: **10.11.2021**
(21) Anmeldenummer: 17702370.2
(22) Anmeldetag: 31.01.2017
(51) Int. Cl.: H05K 7/14, H02B 1/052

(54) **TRÄGERANORDNUNG ZUM TRAGEN EINES ELEKTRONIKGEHÄUSES**
CARRIER ASSEMBLY FOR CARRYING AN ELECTRONICS HOUSING
ENSEMBLE SUPPORT POUR SUPPORTER UN BOÎTIER ÉLECTRONIQUE

(30) Priorität: 15.02.2016 DE 102016102612
(43) Veröffentlichungstag der Anmeldung: 26.12.2018
(73) Patentinhaber: Phoenix Contact GmbH & Co. KG, 32825 Blomberg (DE)
(72) Erfinder: KETTERN, Markus, 32657 Lemgo (DE); HOLSTE, Dieter, 32760 Detmold (DE)
(74) Vertreter: Muth, Bruno
(86) Internationale Anmeldenummer: PCT/EP2017/052042
(87) Internationale Veröffentlichungsnummer: WO 2017/140493

(56) Entgegenhaltungen:
- EP-A2- 0 896 504
- DE-A1- 19 807 710
- DE-A1-102011 110 182
- US-A1- 2002 072 256

## Beschreibung

Die Erfindung betrifft eine Trägeranordnung zum Tragen eines Elektronikgehäuses nach dem Oberbegriff des Anspruchs 1.

Eine derartige Trägeranordnung dient beispielsweise zum Tragen eines Elektronikgehäuses, das eine Elektronik einfassen kann. An das Elektronikgehäuse können beispielsweise elektrische Leiter anzuschließen sein, um eine elektrische Versorgung an der durch das Elektronikgehäuse eingefassten Elektronik bereitzustellen, Sensorsignale der Elektronik zuzuführen oder sonstige Datensignale mit der Elektronik auszutauschen. Über die Trägeranordnung kann das Elektronikgehäuse beispielsweise an einer Tragschiene festzulegen sein, wobei die Tragschiene ausgebildet ist, mehrere modulare Einheiten zu tragen, die nebeneinander an die Tragschiene angesetzt werden können, sodass unter Verwendung modularer Elektronikgehäuse, Reihenklemmen oder anderer Einrichtungen eine Anlage geschaffen werden kann, die beispielsweise steuernde, auswertende oder sonstige Funktionen übernehmen kann.

Die Trägeranordnung umfasst einen Sockel und ein mit dem Sockel verriegelbares Trägerelement. Das Elektronikgehäuse kann an einen Steckplatz der Trägeranordnung angesetzt werden und ist in angesetzter Stellung mit der Trägeranordnung verbunden und darüber an der Trägeranordnung gehalten. Weiter weist die Trägeranordnung ein an dem Trägerelement verstellbar angeordnetes Verriegelungselement auf, das in einer verriegelten Stellung den Sockel mit dem Trägerelement verriegelt und bei an den Steckplatz angesetztem Elektronikgehäuse in der verriegelten Stellung derart blockiert ist, dass das Verriegelungselement nicht aus der verriegelten Stellung heraus bewegbar ist.

In der DE 10 2011 110 182 A1 ist eine Trägeranordnung für ein Elektronikgehäuse offenbart. Die Trägeranordnung weist ein erstes Modulteil und ein zweites Modulteil auf. Um die beiden Modulteile miteinander zu sichern, ist ein Sicherungselement vorgesehen. Das Elektronikgehäuse weist einen Blockierabschnitt auf, der derart ausgebildet ist, dass das Sicherungselement in der zusammengesetzten Anordnung daran gehindert bzw. blockiert wird, sich in die zweite Position zu bewegen, in der das erste Modulteil und das zweite Modulteil voneinander lösbar sind. Das erste Modulteil wird dadurch blockiert, bis das Elektronikgehäuse demontiert ist. Das Abnehmen und Lösen des ersten Modulteils von dem zweiten Modulteil ist nur möglich, wenn das Elektronikgehäuse demontiert ist.

Die DE 198 07 710 A1 beschreibt eine Trägeranordnung, bei welcher ein Anschlussmodul von einem Basismodul nur entfernt werden kann, wenn zuvor das Elektronikmodul aus der Aufnahmeposition des Basismoduls entfernt worden ist, denn das Anschlussmodul wird beim Lösen aus seiner Verrastung am Basismodul in einer Bewegungsrichtung senkrecht zur Richtung der Kontaktierung der Kontaktbereiche bewegt, so dass diese Bewegung des Anschlussmoduls nur dann möglich ist, wenn zuvor das Elektronikmodul entfernt wurde und die Kontaktbereiche dekontaktiert worden sind.

Aus der DE 20 27 157 A1 ist eine Trägeranordnung bekannt, die an eine Tragschiene angesetzt werden kann. Mit der Trägeranordnung kann ein Gehäuse eines elektrischen Installationsgerätes verbunden werden.

Bei einer aus der DE 100 36 853 C2 bekannten Verbindungseinrichtung weist ein Gehäuse eine Rastfeder auf, mit der das Gehäuse an einem Einbaurahmen festgelegt werden kann.

Die DE 101 19 457 C1 beschreibt einen Träger, der an einer Tragschiene angeordnet werden kann und einen Steckplatz zum rastenden Verbinden eines Gehäuses mit dem Träger ausbildet.

Aus der EP 0 909 122 B1 ist ein elektronisches Gerät zum Aufsetzen auf eine Tragschiene bekannt. Das elektronische Gerät umfasst ein Gehäuse, das aus einem mit der Tragschiene lösbar verbindbaren Gehäuseunterteil und einem mit dem Gehäuseunterteil lösbar verbindbaren Gehäuseoberteil besteht.

Die US 6,840,819 B2 beschreibt eine Trägeranordnung, die einen Steckplatz zum Ansetzen eines Elektronikgehäuses ausbildet. Die Trägeranordnung kann an einer Tragschiene angeordnet werden, um auf diese Weise das Elektronikgehäuse an der Tragschiene zu halten.

Aufgabe der vorliegenden Erfindung ist es, eine Trägeranordnung bereitzustellen, die einerseits eine feste Verbindung eines Elektronikgehäuses beispielsweise an einer Tragschiene ermöglicht und zudem komfortabel beispielsweise zum Ansetzen an eine Tragschiene handhabbar ist.

Diese Aufgabe wird durch einen Gegenstand mit den Merkmalen des Anspruchs 1 gelöst.

Demnach ist das Verriegelungselement ausgebildet, sich bei Ansetzen des Elektronikgehäuses an den Steckplatz aus einer entriegelten Stellung, in der das Verriegelungselement den Sockel nicht mit dem Trägerelement verriegelt, in die verriegelte Stellung zu verstellen.

Mittels des bereitgestellten Verriegelungselements wird eine feste Verriegelung zwischen dem Trägerelement und dem Sockel bereitgestellt, die dazu ausgelegt sein kann, auch große Elektronikgehäuse fest und zuverlässig zu tragen. Das Verriegelungselement dient dazu, in seiner verriegelten Stellung den Sockel mit dem Trägerelement zu verriegeln. Das Verriegelungselement kann hierzu zwischen einer entriegelten Stellung und einer verriegelten Stellung bewegt werden und ist in der verriegelten Stellung blockiert, wenn ein Elektronikgehäuse an den durch die Trägeranordnung gebildeten Steckplatz angesetzt ist.

Weil das Verriegelungselement in seiner verriegelten Stellung blockiert ist, wenn ein Elektronikgehäuse an den Steckplatz der Trägeranordnung angesetzt ist, kann die Verriegelung zwischen dem Sockel und dem Trägerelement nicht gelöst werden, wenn sich ein Elektronikgehäuse an der Trägeranordnung befindet. Bei angesetztem Elektronikgehäuse ist der Sockel somit fest und zuverlässig mit dem Trägerelement verbunden. Erst nach Entnehmen des Elektronikgehäuses kann die Verriegelung zwischen dem Sockel und dem Trägerelement aufgehoben werden, sodass das Trägerelement von dem Sockel getrennt werden kann.

Dadurch, dass eine zweiteilige Trägeranordnung mit einem Sockel und einem Trägerelement, die lösbar miteinander zu verbinden sind, bereitgestellt wird, ist möglich, modular unterschiedliche Sockel und Trägerelemente miteinander zu verbinden. Beispielsweise kann ein einheitlicher Sockel zum Festlegen der Trägeranordnung an einer Tragschiene vorgesehen sein. Der Sockel kann mit unterschiedlichen Trägerelementen verbunden werden, die das Ansetzen unterschiedlicher Elektronikgehäuse an die Trägeranordnung ermöglichen.

Das Verriegelungselement dient hierbei dazu, das Trägerelement mit dem Sockel zu verriegeln, wenn ein Elektronikgehäuse an die Trägeranordnung angesetzt ist. Wenn ein Elektronikgehäuse an die Trägeranordnung angesetzt ist, wird somit ein fester Verbund zwischen Elektronikgehäuse, Trägerelement und Sockel geschaffen, indem das Elektronikgehäuse beispielsweise in dem Steckplatz verrastet und das Trägerelement mit dem Sockel verriegelt ist.

Das Verriegelungselement ist erfindungsgemäß ausgebildet, sich bei Ansetzen des Elektronikgehäuses an den Steckplatz aus der entriegelten Stellung in die verriegelte Stellung zu verstellen. Wird das Elektronikgehäuse an den Steckplatz angesetzt, so wirkt das Elektronikgehäuse auf das Verriegelungselement ein und verstellt das Verriegelungselement aus der entriegelten Stellung in die verriegelte Stellung, sodass die Verriegelung zwischen dem Trägerelement und dem Sockel bei Ansetzen des Elektronikgehäuses selbsttätig hergestellt wird. Ist das Elektronikgehäuse in den Steckplatz eingesetzt, so wird das Verriegelungselement in der verriegelten Stellung gehalten und ist somit in der verriegelten Stellung blockiert, sodass die Verriegelung zwischen dem Trägerelement und dem Sockel nicht gelöst werden kann.

In einer vorteilhaften Ausgestaltung ist das Verriegelungselement in Richtung der entriegelten Stellung gegenüber dem Trägerelement federvorgespannt. Das Überführen des Verriegelungselements in die verriegelte Stellung erfolgt somit gegen die Federvorspannung. Wird das Elektronikgehäuse sodann von der Trägeranordnung wieder gelöst, stellt sich das Verriegelungselement aufgrund einer Federvorspannung selbsttätig in die entriegelten Stellung zurück, sodass die Verriegelung bei Entnehmen des Elektronikgehäuses selbsttätig aufgehoben wird und somit das Trägerelement von dem Sockel lösbar ist.

In einer Ausführungsform ist das Verriegelungselement schwenkbar an dem Trägerelement gehalten. Zum Überführen des Verriegelungselements zwischen der entriegelten Stellung und der verriegelten Stellung kann das Verriegelungselement somit relativ zu dem Trägerelement verschwenkt werden.

Hierzu ist anzumerken, dass grundsätzlich auch andere Ausführungsformen denkbar und möglich sind. Insbesondere kann das Verriegelungselement beispielsweise auch verschiebbar an dem Trägerelement angeordnet sein und durch Verschieben zwischen der entriegelten Stellung und der verriegelten Stellung bewegt werden.

Zum Festlegen des Verriegelungselements an dem Trägerelement kann das Verriegelungselement an einem ersten Ende beispielsweise ein Befestigungselement aufweisen, das z.B. hakenförmig ausgebildet sein kann. Über das Befestigungselement kann das Verriegelungselement beispielsweise in eine zugeordnete Befestigungseinrichtung auf Seiten des Trägerelements eingehängt werden, sodass das Verriegelungselement schwenkbar an dem Trägerelement gehalten ist. An einem von dem ersten Ende abliegenden, zweiten Ende weist das Verriegelungselement demgegenüber ein Formschlusselement zum Eingriff mit einem zugeordneten Rastelement des Sockels auf. Über das Formschlusselement wird die Verriegelung zwischen dem Trägerelement und dem Sockel hergestellt, indem das Formschlusselement, das nach Art eines Hinterschnitts ausgestaltet sein kann, zum Verriegeln ein zugeordnetes Rastelement des Sockels hintergreift und dadurch das Trägerelement formschlüssig an dem Sockel festlegt. Der Kraftfluss verläuft hierbei zwischen dem Befestigungselement am ersten Ende des Verriegelungselement und dem Formschlusselement am zweiten Ende des Verriegelungselements. Über diesen Kraftfluss werden Kräfte vom Trägerelement in den Sockel und darüber zum Beispiel in eine Tragschiene, an der der Sockel angeordnet ist, eingeleitet.

In einer Ausführungsform umfasst das Verriegelungselement eine entlang einer Erstreckungsebene erstreckte Basis und zumindest einen an der Basis erstreckten, quer zur Erstreckungsebene von der Basis vorstehenden Schenkel, an dem das zumindest eine Formschlusselement zum Eingriff mit einem zugeordneten Rastelement des Sockels angeordnet ist. An der Basis ist beispielsweise das zumindest eine Befestigungselement angeordnet, während der zumindest eine Schenkel das zumindest eine Formschlusselement trägt. Dadurch, dass der oder die Schenkel quer von der Basis vorstehen, wird die Festigkeit des Verriegelungselements, das beispielsweise als Blechteil aus Federstahl hergestellt sein kann, strukturell verstärkt.

An der Basis des Verriegelungselements kann ein Federschenkel angeordnet sein derart, dass der Federschenkel von der Basis vorsteht und bei Überführen des Verriegelungselements in die verriegelte Stellung vorspannend in Anlage mit dem Trägerelement gelangt. Über diesen Federschenkel kann eine Federvorspannung bereitgestellt werden, die das Verriegelungselement in Richtung der entriegelten Stellung vorspannt.

In einer konkreten Ausgestaltung können an der Basis beispielsweise zwei quer zueinander versetzte Befestigungselemente und zwei quer zueinander versetzte Schenkel mit jeweils einem daran angeordneten Formschlusselement ausgebildet sein. Die Schenkel erstrecken sich beispielsweise seitlich entlang der Basis und stehen quer zur Erstreckungsebene von der Basis vor. An jedem Schenkel ist ein Formschlusselement ausgebildet.

Das Verriegelungselement ist z.B. einstückig ausgebildet und beispielsweise aus einem Federstahl gefertigt.

Das Verriegelungselement durchgreift, in einer Ausführungsform, beispielsweise eine erste Öffnung des Trägerelements und greift in eine zweite Öffnung des Sockels ein. Das Verriegelungselement liegt beispielsweise in der ersten Öffnung des Trägerelements ein und ist in dieser Öffnung verstellbar. Bei Ansetzen des Trägerelements an den Sockel gelangt das Verriegelungselement in Eingriff mit der zweiten Öffnung des Sockels und stellt bei Überführen in die verriegelte Stellung eine formschlüssige Verbindung zwischen dem Trägerelement und dem Sockel her.

Um das Trägerelement fest und zuverlässig mit dem Sockel zu verbinden, können mehrere Verriegelungseinrichtungen vorgesehen sein. So ist vorzugsweise zusätzlich zu dem Verriegelungselement zumindest eine weitere Verriegelungseinrichtung vorgesehen, die das Trägerelement an anderer Stelle mit dem Sockel verbindet. Beispielsweise kann somit das Trägerelement an zwei zueinander versetzten Stellen (bezogen auf eine Längserstreckungsrichtung des Trägerelements und des Sockels quer zu einer Einsteckrichtung, in die das Elektronikgehäuse in den Steckplatz einzusetzen ist, und quer zu einer Längsrichtung einer Tragschiene, an die der Sockel anzusetzen ist) mit dem Sockel zu verriegeln sein, wobei grundsätzlich auch denkbar und möglich ist, eine Verriegelung an mehr als zwei, beispielsweise an drei Stellen bereitzustellen.

Eine vorteilhafte Baugruppe umfasst eine Trägeranordnung nach der vorangehend beschriebenen Art sowie ein Elektronikgehäuse, das in den durch die Trägeranordnung gebildeten Steckplatz eingesetzt werden kann. Ist das Elektronikgehäuse an die Trägeranordnung angesetzt, so wird über das Verriegelungselement ein fester Verbund zwischen dem Sockel und dem Trägerelement geschaffen, sodass das Elektronikgehäuse über das Trägerelement fest, zuverlässig und belastbar an dem Sockel gehalten werden kann.

Die der Erfindung zugrunde liegende Aufgabe soll nachfolgend anhand der in den Figuren dargestellten Ausführungsbeispiele näher erläutert werden. Es zeigen:
- Fig. 1: eine perspektivische Darstellung einer Trägeranordnung, an die ein Elektronikgehäuse angesetzt werden kann;
- Fig. 2A: eine stirnseitige Ansicht der Trägeranordnung, bei Ansetzen eines Trägerelements an einen Sockel der Trägeranordnung;
- Fig. 2B: eine Schnittansicht entlang der Linie I-I gemäß Fig. 2A;
- Fig. 3A: einen stirnseitige Ansicht der Trägeranordnung bei Ansetzen eines Elektronikgehäuses;
- Fig. 3B: eine Schnittansicht entlang der Linie II-II gemäß Fig. 3A;
- Fig. 3C: eine perspektivische Ansicht der Baugruppe;
- Fig. 4A: eine stirnseitige Ansicht der Trägeranordnung bei angesetztem Elektronikgehäuse;
- Fig. 4B: eine Schnittansicht entlang der Linie III-III gemäß Fig. 4A;
- Fig. 4C: eine perspektivische Ansicht der Baugruppe;
- Fig. 5A, 5B: Ansichten eines Verriegelungselements zum Verriegeln des Trägerelements mit dem Sockel;
- Fig. 6A: eine Frontalansicht des Verriegelungselements;
- Fig. 6B: eine Schnittansicht entlang der Linie IV-IV gemäß Fig. 6A;
- Fig. 6C: eine Seitenansicht des Verriegelungselements; und
- Fig. 6D: eine Draufsicht auf das Verriegelungselement.

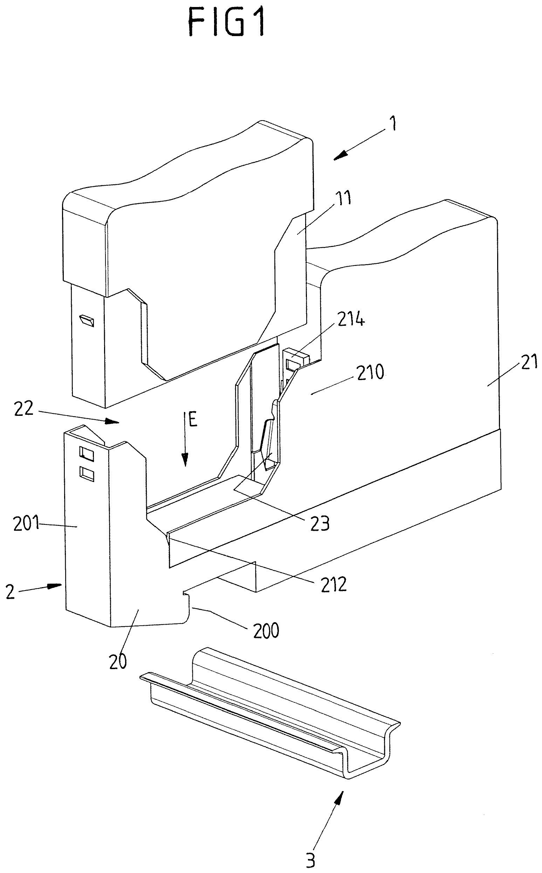

Fig. 1 zeigt eine Ansicht einer Trägeranordnung 2, die einen Sockel 20 und ein daran angesetztes Trägerelement 21 aufweist, über eine Befestigungsstelle 200 an dem Sockel 20 einerseits an eine Tragschiene 3 angesetzt werden kann und andererseits einen Steckplatz 22 zum Aufnehmen eines Elektronikgehäuses 1 ausbildet.

Eine derartige Trägeranordnung 2 dient zum Anordnen eines Elektronikgehäuses 1 an einer Tragschiene 3. An die Tragschiene 3 können hierbei in modularer Weise mehrere Trägeranordnungen 2 mit Elektronikgehäusen 1 eingesetzt werden, sodass an der Tragschiene 3, gegebenenfalls im Verbund mit anderen Bauteilen wie Reihenklemmen oder dergleichen, eine elektrische Anlage geschaffen werden kann, die beispielsweise steuernde, auswertende oder verteilende Funktionen oder dergleichen übernehmen kann.

Die Trägeranordnung 2 mit dem Sockel 20 und dem Trägerelement 21 ist zweiteilig ausgebildet. Der Sockel 20 und das Trägerelement 21 weisen hierbei jeweils ein Führungselement 201, 210 auch, die gemeinsam den Steckplatz 22 ausbilden und zwischen die das Elektronikgehäuse 1 in eine Einsteckrichtung E eingeschoben werden kann. An dem Elektronikgehäuse 1 sind hierzu Einschubbereiche 10, 11 ausgebildet, mit denen das Elektronikgehäuse 1 zwischen die Führungselemente 201, 210 eingeschoben werden kann. Die Führungselemente 201, 210 können bei angesetztem Elektronikgehäuse 1 mit dem Elektronikgehäuse 1 verrasten, um das Elektronikgehäuse 1 mit der Trägeranordnung 2 zu verbinden.

Das Trägerelement 21 weist, außerhalb des Steckplatz 22, z.B. eine Anordnung von Einstecköffnungen auf, in die jeweils ein elektrischer Leiter eingesteckt werden kann, um auf diese Weise elektrische Leiter der Trägeranordnung 1 elektrisch zu kontaktieren. An dem Steckplatz 22 kann zudem ein elektrischer Steckverbinder ausgebildet sein, der bei Ansetzen des Elektronikgehäuses 1 an den Steckplatz 22 steckend mit dem Elektronikgehäuse 1 in Eingriff gelangt und somit eine elektrische Kontaktierung zwischen der Trägeranordnung 2 und dem Elektronikgehäuse 1 herstellt. Über ein solches Steckverbinderteil können somit elektrische Signale zwischen den Anschlusseinrichtungen 215 und den daran angeschlossenen elektrischen Leitern sowie einer in dem Elektronikgehäuse 1 eingefassten Elektronik ausgetauscht werden.

Das Trägerelement 21 ist lösbar an den Sockel 20 angesetzt, wobei denkbar und möglich ist, unterschiedliche Trägerelemente 21 in modularer Weise mit dem Sockel 20 zu verbinden, um die Trägeranordnung 2 zum Aufnehmen unterschiedlicher Elektronikgehäuse 1 anzupassen.

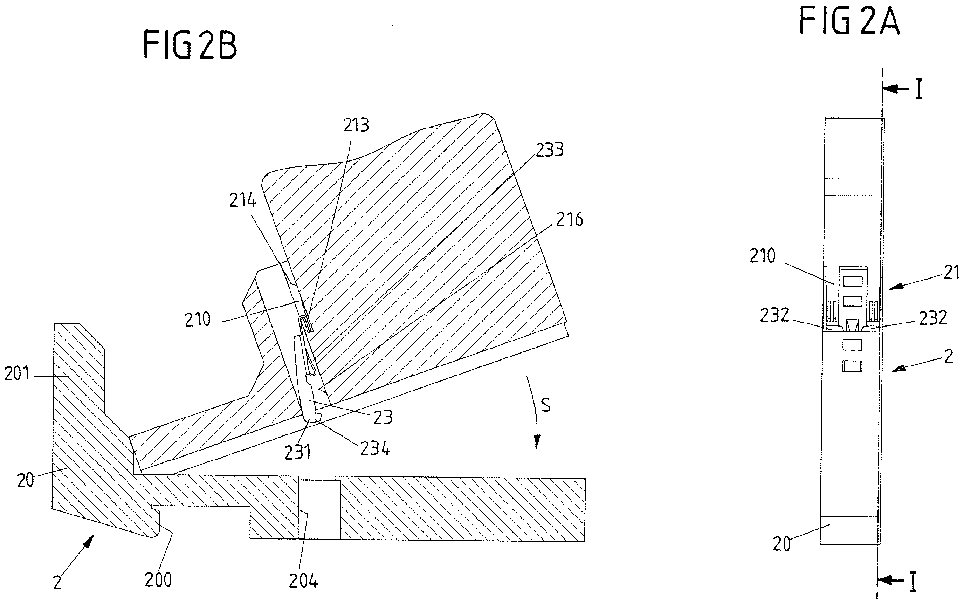

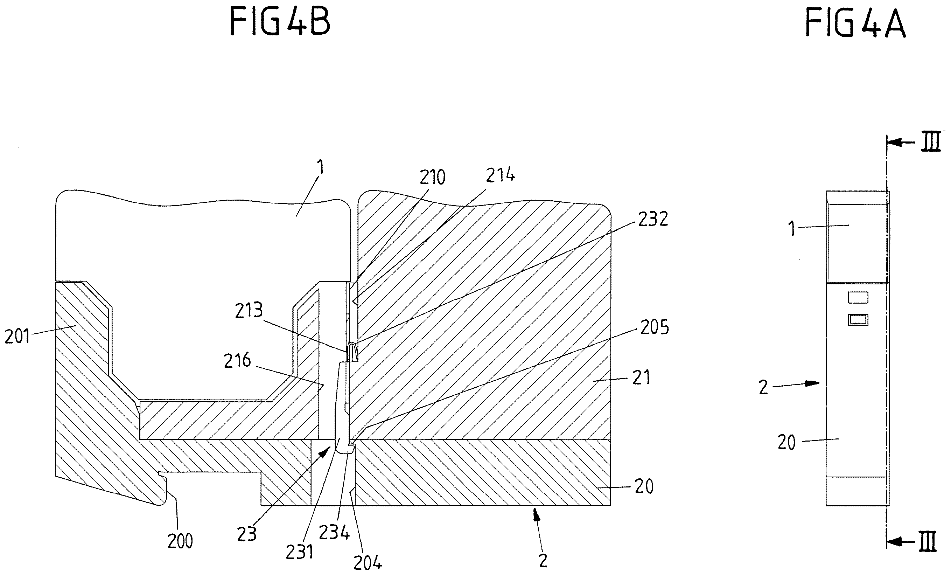

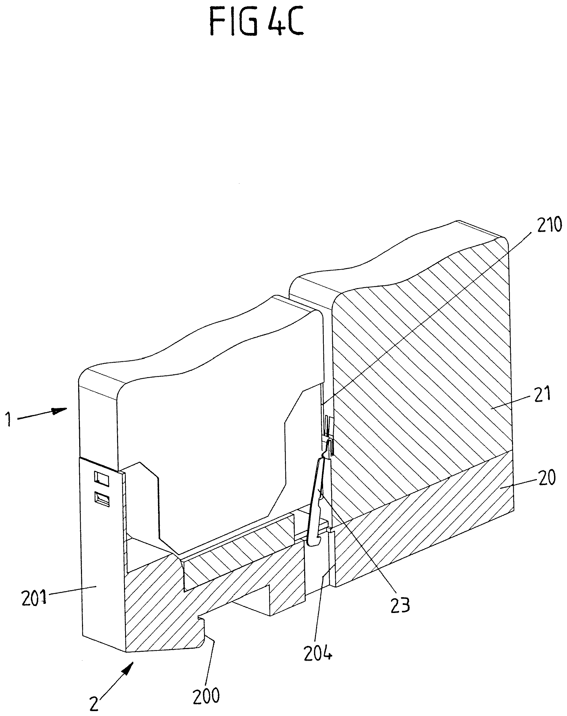

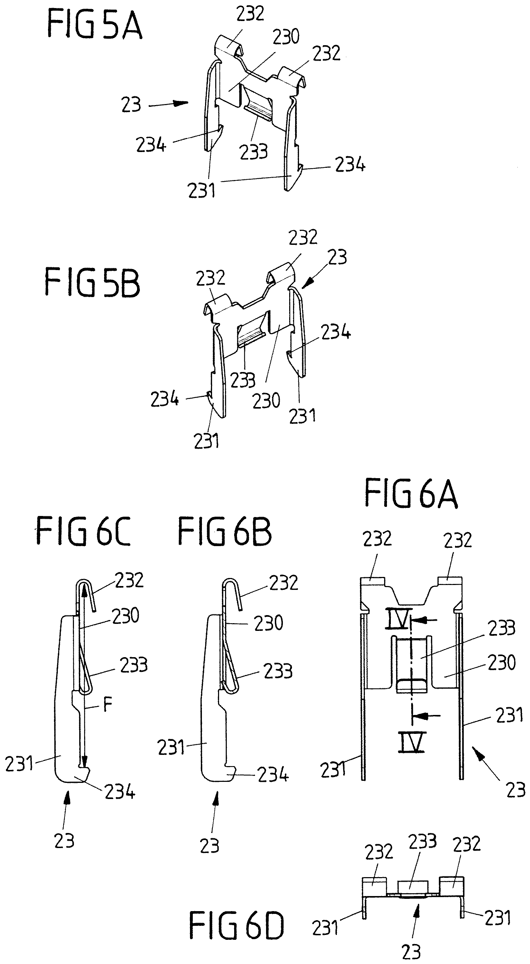

Fig. 2A, 2B, 3A-3C und 4A-4C zeigen die Trägeranordnung 2 zusammen mit dem Elektronikgehäuse 1 in unterschiedlichen Stellungen bei Zusammenfügen des Trägerelements 21 mit dem Sockel 20 (Fig. 2A und 2B), bei Ansetzen des Elektronikgehäuses 1 (3A bis 3C) und in angesetzter Stellung des Elektronikgehäuses 1 (Fig. 4A bis 4C). Fig. 5A, 5B und 6A bis 6D zeigen gesonderte Ansichten des Verriegelungselements 23.

Zum Ansetzen des Trägerelements 21 an den Sockel 20 wird das Trägerelement 21, wie aus der Schnittansicht gemäß Fig. 2B ersichtlich, mit einem Ende an den Sockel 20 angesetzt, und das Trägerelement 21 wird in eine Schwenkrichtung S hin zu dem Sockel 20 verschwenkt. Das Verriegelungselement 23 ist mit Befestigungselementen 232 in Form von Haken an einer Basis 230 (siehe Fig. 5A und 5B) an eine zugeordnete Befestigungseinrichtung 213 in Form von Stegen auf Seiten des Trägerelements 21 angesetzt und darüber derart an dem Trägerelement 21 gehalten, dass das Verriegelungselement 23 in einer Öffnung 216 des Trägerelements 21 einliegt.

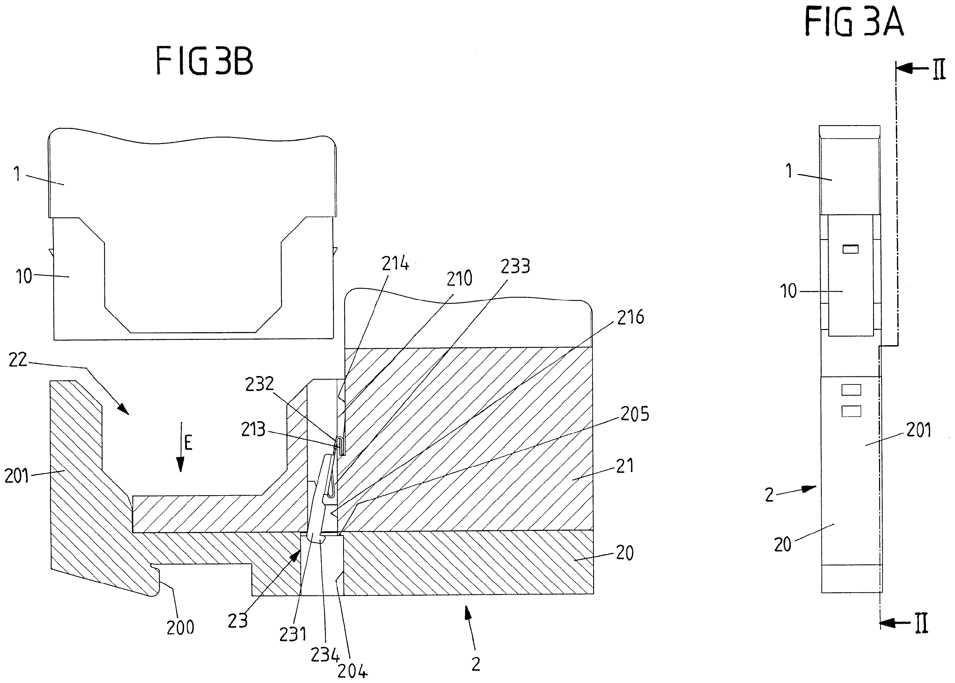

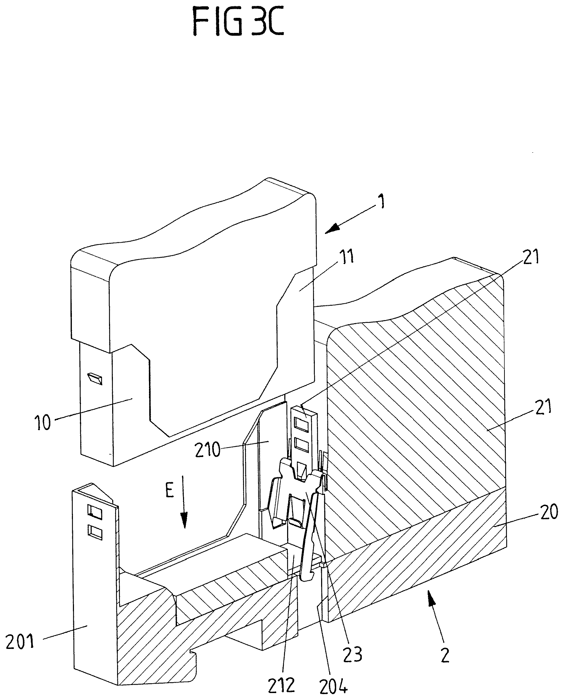

Wie aus Fig. 5A, 5B und 6A bis 6D ersichtlich, weist das Verriegelungselement 23 zwei hakenförmige Befestigungselemente 232 auf, über die das Verriegelungselement 23 an einer Grundseite 214 des im Querschnitt U-förmigen Führungselements 210 des Trägerelements 21 angesetzt ist, wobei hierzu das Verriegelungselement 23 mit den Befestigungselementen 232 jeweils einen zugeordneten Steg an der Grundseite 214 das Führungselements 210 umgreift. In der Stellung gemäß Fig. 2B bei Ansetzen des Trägerelements 21 an den Sockel 20 befindet sich das Verriegelungselement 23 in einer schrägen Stellung in der Öffnung 216 und kann, durch Schwenken des Trägerelements 21 in die Schwenkrichtung S hin zum Sockel 20, mit einer Öffnung 204 auf Seiten des Sockels 20 in Eingriff gebracht werden, wie dies beispielsweise aus der Schnittansicht gemäß Fig. 3B ersichtlich ist.

Ist das Trägerelement 21 an den Sockel 20 angesetzt worden, so kann ein Elektronikgehäuse 1 in den zugeordneten Steckplatz 22 zwischen den Führungselementen 201, 210 eingeschoben werden, wie dies in Fig. 3A bis 3C dargestellt ist. Hierzu wird das Elektronikgehäuse 1 mit seinen Einschubbereichen 10, 11 in Eingriff mit den Führungselementen 101, 210 gebracht, bis das Elektronikgehäuse 1 mit der Trägeranordnung 2 verrastet.

Bei Ansetzen des Elektronikgehäuses 1 an die Trägeranordnung 2 läuft das Elektronikgehäuse 1 mit seinem dem Führungselement 210 des Trägerelements 21 zugeordneten Einschubbereich 11 auf das Verriegelungselement 23 auf und verschwenkt dies um die Befestigungselemente 232, sodass das Verriegelungselement 23 mit nach Art von Haken ausgebildeten Formschlusselementen 234 an Schenkeln 231 mit einem Rastelement 205 in Form einer Rastkante des Sockels 20 in Eingriff gelangt, wie dies aus der Schnittansicht gemäß Fig. 4B ersichtlich ist.

Wie aus den Detailansichten gemäß Fig. 5A, 5B und 6A bis 6D ersichtlich, erstrecken sich die Schenkel 231 seitlich an der Basis 230 des Verriegelungselements 23 und stehen quer zur flächigen Erstreckungsebene der Basis 230 von dieser vor. Die Schenkel 131 tragen an von den Befestigungselementen 232 abgewandten Enden die Formschlusselemente 234, über die eine formschlüssige Verbindung zwischen dem Trägerelement 21 und dem Sockel 20 hergestellt wird, wenn das Verriegelungselement 23 in Eingriff mit der Rastkante 205 auf Seiten des Sockels 20 geschwenkt wird.

Das Verriegelungselement 23 ist, bei dem dargestellten Ausgangsbeispiel, einstückig beispielsweise als Blechteil aus Federstahl gefertigt. Dadurch, dass sich die Schenkel 231 seitlich an der Basis 230 erstrecken und quer zur Erstreckungsebene von der Basis 230 vorstehen, wird ein formstabiles Bauteil geschaffen, das eine zuverlässige, belastbare Verriegelung zwischen dem Trägerelement 21 und dem Sockel 20 herstellen kann.

In verriegelter Stellung besteht ein Kraftfluss F (siehe Fig. 6C) zwischen den Befestigungselementen 232 einerseits und den Formschlusselementen 234 an den Schenkeln 231 andererseits. Über diesen Kraftfluss F können Kräfte von Seiten des Trägerelements 21 in den Sockel 20 und darüber in die Tragschiene 3 abgeleitet werden, sodass eine belastbare Verbindung zwischen dem Elektronikgehäuse 1, dem Trägerelement 21 und dem Sockel 20 geschaffen wird.

Ist das Elektronikgehäuse 1 an die Trägeranordnung 2 angesetzt, so hält das Elektronikgehäuse 1 das Verriegelungselement 23 in seiner verriegelten Stellung (siehe Fig. 4B). Das Verriegelungselement 23 ist somit in der verriegelten Stellung blockiert, wenn das Elektronikgehäuse 1 an die Trägeranordnung 2 angesetzt ist, sodass die Verriegelung zwischen dem Trägerelement 21 und dem Sockel 20 bei angesetztem Elektronikgehäuse 1 nicht ohne weiteres, jedenfalls nicht ohne Entnehmen des Elektronikgehäuses 1, gelöst werden kann.

Bei Überführen des Verriegelungselements 23 in seine verriegelte Stellung gelangt das Verriegelungselement 23 mit einem von der Basis 230 vorstehenden Federschenkel 233 in Anlage mit dem Trägerelement 21. Bei Überführen des Verriegelungselements 23 in die verriegelte Stellung wird dieser Federschenkels 133 gespannt und stellt auf diese Weise eine Federvorspannung zwischen dem Verriegelungselement 23 und dem Trägerelement 21 in Richtung der entriegelten Stellung des Verriegelungselements 23 zur Verfügung. Dies hat zur Folge, dass bei Entnehmen des Elektronikgehäuses 1 aus dem Steckplatz 22 das Verriegelungselement 23 selbsttätig zurück in seine entriegelte Stellung verschwenkt und somit die Verriegelung zwischen dem Trägerelement 21 und dem Sockel 20 aufgehoben wird. Wird das Elektronikgehäuse 1 somit von dem Steckplatz 22 entnommen, können das Trägerelement 21 und der Sockel 20 voneinander getrennt werden.

Wie aus den Detailansichten gemäß Fig. 5A, 5B und 6A bis 6D ersichtlich, sind die Befestigungselemente 232 einerseits und die Formschlusselemente 234 andererseits quer zur Einsteckrichtung E und quer zur Längserstreckungsrichtung des Sockels 20 und des Trägerelements 21 zueinander versetzt.

Eine Trägeranordnung der hier beschriebenen Art ist grundsätzlich zum Tragen von ganz unterschiedlichen Elektronikgehäusen geeignet und ist insofern nicht auf das dargestellte Ausführungsbeispiel beschränkt.

Grundsätzlich kann eine Verriegelung zwischen dem Trägerelement und dem Sockel auch an mehr als zwei Orten entlang der Längserstreckungsrichtung des Sockels und des Trägerelements hergestellt werden, um auf diese Weise eine hoch belastbare Verbindung zwischen dem Trägerelement und dem Sockel bereitzustellen.

Die Anwendungsmöglichkeiten einer Baugruppe einer solchen Trägeranordnung und eines Elektronikgehäuses sind vielfältig. Insbesondere kann in dem Elektronikgehäuse eine Elektronik eingefasst sein, die steuernde, auswertende oder sonstige Funktionen übernehmen kann.

### Bezugszeichenliste

- 1: Elektronikgehäuse
- 10, 11: Einschubbereich
- 2: Trägeranordnung
- 20: Sockel
- 200: Befestigungsstelle
- 201: Führungselement
- 204: Eingriffsöffnung
- 205: Rastelement (Rastkante)
- 21: Trägerelement
- 210: Führungselement
- 213: Steg
- 214: Grundseite
- 216: Öffnung
- 22: Steckplatz
- 23: Verriegelungselement
- 230: Basis
- 231: Schenkel
- 232: Befestigungselement (Haken)
- 233: Federschenkel
- 234: Formschlusselement (Hakenelement)
- 3: Tragschiene
- E: Einsteckrichtung
- F: Kraftfluss
- S: Schwenkrichtung

## Patentansprüche

1. Trägeranordnung (2) zum Tragen eines Elektronikgehäuses (1), mit
- einem Sockel (20),
- einem mit dem Sockel (20) verriegelbaren Trägerelement (21)
- einem Steckplatz (22) zum Ansetzen des Elektronikgehäuses (1), und
- einem an dem Trägerelement (21) verstellbar angeordneten Verriegelungselement (23), das in einer verriegelten Stellung den Sockel (20) mit dem Trägerelement (21) verriegelt und bei an den Steckplatz (22) angesetztem Elektronikgehäuse (1) in der verriegelten Stellung derart blockiert ist, dass das Verriegelungselement (23) nicht aus der verriegelten Stellung heraus bewegbar ist,
**dadurch gekennzeichnet, dass** das Verriegelungselement (23) ausgebildet ist, sich bei Ansetzen des Elektronikgehäuses (1) an den Steckplatz (22) aus einer entriegelten Stellung, in der das Verriegelungselement (23) den Sockel (20) nicht mit dem Trägerelement (21) verriegelt, in die verriegelte Stellung zu verstellen.

2. Trägeranordnung (2) nach Anspruch 1, **dadurch gekennzeichnet, dass** das Verriegelungselement (23) in Richtung der entriegelten Stellung gegenüber dem Trägerelement (21) federvorgespannt ist.

3. Trägeranordnung (2) nach Anspruch 1 oder 2, **dadurch gekennzeichnet, dass** das Verriegelungselement (23) schwenkbar an dem Trägerelement (21) gehalten ist.

4. Trägeranordnung (2) nach einem der vorangehenden Ansprüche, **dadurch gekennzeichnet, dass** das Verriegelungselement (23) an einem ersten Ende zumindest ein Befestigungselement (232), über das das Verriegelungselement (23) verstellbar an dem Trägerelement (21) befestigt ist, und an einem von dem ersten Ende abliegenden zweiten Ende zumindest ein Formschlusselement (234) zum Eingriff mit einem zugeordneten Rastelement (205) des Sockels (20) aufweist.

5. Trägeranordnung (2) nach Anspruch 4, **dadurch gekennzeichnet, dass** das Verriegelungselement (23) eine entlang einer Erstreckungsebene erstreckte Basis (230) und zumindest einen an der Basis (230) erstreckten, quer zur Erstreckungsebene von der Basis (230) vorstehenden Schenkel (231), an dem das zumindest eine Formschlusselement (234) zum Eingriff mit einem zugeordneten Rastelement (205) des Sockels (20) angeordnet ist, aufweist.

6. Trägeranordnung (2) nach Anspruch 5, **dadurch gekennzeichnet, dass** das Verriegelungselement (23) einen an der Basis (230) angeordneten Federschenkel (233) zum Vorspannen des Verriegelungselements (23) gegenüber dem Trägerelement (21) aufweist.

7. Trägeranordnung (2) nach einem der Ansprüche 4 bis 6, **dadurch gekennzeichnet, dass** das Verriegelungselement (23) zwei quer zueinander versetzte Befestigungselemente (232) und zwei quer zueinander versetzte Schenkel (231) mit jeweils einem daran angeordneten Formschlusselement (234) aufweist.

8. Trägeranordnung (2) nach einem der vorangehenden Ansprüche, **dadurch gekennzeichnet, dass** das Verriegelungselement (23) eine erste Öffnung (216) des Trägerelements (21) durchgreift und in eine zweite Öffnung (204) des Sockels (20) eingreift.

9. Baugruppe, mit einer Trägeranordnung (2) nach einem der vorangehenden Ansprüche und einem Elektronikgehäuse (1), das an den Steckplatz (22) der Trägeranordnung (1) ansetzbar ist.

## Claims

1. Carrier arrangement (2) for carrying an electronics housing (1), comprising
- a base (20),
a carrier element (21) which can be locked to the base (20),
a plug-in location (22) for fitting the electronics housing (1), and
- a locking element (23) which is arranged in an adjustable manner on the carrier element (21) and which locks the base (20) to the carrier element (21) in a locked position and, with the electronics housing (1) fitted at the plug-in location (22), is blocked in the locked position in such a way that the locking element (23) cannot be moved out of the locked position, **characterized in that** the locking element (23) is designed to be adjusted from an unlocked position, in which the locking element (23) does not lock the base (20) to the carrier element (21), to the locked position when the electronics housing (1) is fitted at the plug-in location (22).

2. Carrier arrangement (2) according to Claim 1, **characterized in that** the locking element (23) is spring-prestressed in relation to the carrier element (21) in the direction of the unlocked position.

3. Carrier arrangement (2) according to Claim 1 or 2, **characterized in that** the locking element (23) is pivotably held on the carrier element (21).

4. Carrier arrangement (2) according to one of the preceding claims, **characterized in that** the locking element (23) has at least one fastening element (232), by means of which the locking element (23) is adjustably fastened to the carrier element (21), at a first end and at least one interlocking element (234) for engaging with an associated latching element (205) of the base (20) at a second end that is averted from the first end.

5. Carrier arrangement (2) according to Claim 4, **characterized in that** the locking element (23) has a base portion (230) which extends along a plane of extent and has at least one limb (231) which extends from the base portion (230), protrudes from the base portion (230) transversely to the plane of extent and on which the at least one interlocking element (234) for engaging with an associated latching element (205) of the base (20) is arranged.

6. Carrier arrangement (2) according to Claim 5, **characterized in that** the locking element (23) has a spring limb (233), which is arranged on the base portion (230), for prestressing the locking element (23) in relation to the carrier element (21).

7. Carrier arrangement (2) according to one of Claims 4 to 6, **characterized in that** the locking element (23) has two fastening elements (232) which are transversely offset in relation to one another and two limbs (231) which are transversely offset in relation to one another and each have an interlocking element (234) arranged on them.

8. Carrier arrangement (2) according to one of the preceding claims, **characterized in that** the locking element (23) passes through a first opening (216) of the carrier element (21) and engages into a second opening (204) of the base (20).

9. Assembly comprising a carrier arrangement (2) according to one of the preceding claims and an electronics housing (1) which can be fitted at the plug-in location (22) of the carrier arrangement (1).

## Revendications

1. Agencement de support (2) pour le support d'un boîtier électronique (1), comprenant
- un socle (20),
- un élément de support (21) verrouillable avec le socle (20),
- un emplacement d'enfichage (22) pour la disposition du boîtier électronique (1), et
- un élément de verrouillage (23) agencé de manière réglable sur l'élément de support (21), qui verrouille le socle (20) avec l'élément de support (21) dans une position verrouillée et qui est bloqué dans la position verrouillée lorsqu'un boîtier électronique (1) est disposé à l'emplacement d'enfichage (22), de telle sorte que l'élément de verrouillage (23) ne peut pas sortir de la position verrouillée,
**caractérisé en ce que** l'élément de verrouillage (23) est configuré pour se régler dans la position verrouillée lors de la disposition du boîtier électronique (1) à l'emplacement d'enfichage (22) à partir d'une position déverrouillée, dans laquelle l'élément de verrouillage (23) ne verrouille pas le socle (20) avec l'élément de support (21).

2. Agencement de support (2) selon la revendication 1, **caractérisé en ce que** l'élément de verrouillage (23) est précontraint par ressort par rapport à l'élément de support (21) dans la direction de la position déverrouillée.

3. Agencement de support (2) selon la revendication 1 ou 2, **caractérisé en ce que** l'élément de verrouillage (23) est maintenu de manière pivotante sur l'élément de support (21).

4. Agencement de support (2) selon l'une quelconque des revendications précédentes, **caractérisé en ce que** l'élément de verrouillage (23) comprend à une première extrémité au moins un élément de fixation (232), par l'intermédiaire duquel l'élément de verrouillage (23) est fixé à l'élément de support (21) de manière réglable, et à une deuxième extrémité éloignée de la première extrémité au moins un élément de complémentarité de forme (234) pour l'engagement avec un élément d'encliquetage associé (205) du socle (20).

5. Agencement de support (2) selon la revendication 4, **caractérisé en ce que** l'élément de verrouillage (23) comprend une base (230) étendue le long d'un plan d'étendue et au moins une branche (231) étendue sur la base (230), saillante perpendiculairement au plan d'étendue à partir de la base (230), sur laquelle l'au moins un élément de complémentarité de forme (234) pour l'engagement avec un élément d'encliquetage associé (205) du socle (20) est agencé.

6. Agencement de support (2) selon la revendication 5, **caractérisé en ce que** l'élément de verrouillage (23) comprend une branche de ressort (233) agencée sur la base (230) pour la précontrainte de l'élément de verrouillage (23) par rapport à l'élément de support (21) .

7. Agencement de support (2) selon l'une quelconque des revendications 4 à 6, **caractérisé en ce que** l'élément de verrouillage (23) comprend deux éléments de fixation (232) décalés perpendiculairement l'un de l'autre et deux branches (231) décalées perpendiculairement l'une de l'autre avec à chaque fois un élément de complémentarité de forme (234) agencé dessus.

8. Agencement de support (2) selon l'une quelconque des revendications précédentes, **caractérisé en ce que** l'élément de verrouillage (23) traverse une première ouverture (216) de l'élément de support (21) et pénètre dans une deuxième ouverture (204) du socle (20).

9. Module, comprenant un agencement de support (2) selon l'une quelconque des revendications précédentes et un boîtier électronique (1), qui peut être disposé à l'emplacement d'enfichage (22) de l'agencement de support (1).
